# EUROPÄISCHE PATENTANMELDUNG

(11) **EP 2 086 110 A2**
(43) Veröffentlichungstag der Anmeldung: **05.08.2009**
(21) Anmeldenummer: 08105768.9
(22) Anmeldetag: 11.11.2008
(51) Int. Cl.: H03G 3/32

(54) **Verfahren zur automatischen Kontrolle mindestens eines akustischen Parameters**

(30) Priorität: 01.02.2008 DE 102008007240
(71) Anmelder: ROBERT BOSCH GMBH, 70442 Stuttgart (DE)
(72) Erfinder: Rosenbaum, Thomas, 71282 Hemmingen (DE)

(57) **Zusammenfassung**

Die Erfindung betrifft ein Verfahren zur automatischen Kontrolle mindestens eines akustischen Parameters einer Audioanlage (6), bei dem ein Mikrophon (8) einer Sprachgarnitur (10) für eine Telefonanlage im Bereich des Kopfes (21) eines Nutzers (12) der Audioanlage angeordnet und als Referenzmikrophon verwendet wird. Weiterhin betrifft die Erfindung ein Mikrophon (8), eine Audioanlage (6), ein Computerprogramm und ein Computerprogrammprodukt.

## Beschreibung

Die Erfindung betrifft ein Verfahren zur automatischen Kontrolle mindestens eines akustischen Parameters, ein Mikrophon, das als Komponente einer Sprachgarnitur für eine mobile Telefonanlage ausgebildet ist, eine Audianlage, ein Computerprogramm und ein Computerprogrammprodukt.

### Stand der Technik

Falls bei einer Autofahrt Radio gehört wird, kann es sein, dass die Klangqualität durch Störgeräusche, die bspw. durch den Motor oder den Fahrtwind während der Fahrt entstehen, beeinträchtigt wird. Derartige Störgeräusche können jedoch durch eine geeignete Lautstärkeregelung verdeckt werden.

In der Druckschrift EP 0 319 777 B1 ist hierzu vorgesehen, dass mit Hilfe eines im Fahrzeuginnenraum angeordneten Mikrophons das Signalgemisch aus Störgeräuschen und von den Lautsprechern der Audioanlage wiedergegebenen Audiosignalen erfasst und aus diesem Signalgemisch das Audiosignal herausgerechnet wird. Das verbleibende Störgeräuschsignal wird zur Steuerung der Wiedergabelautstärke für das Audiosignal verwendet. Zur Bestimmung des Audiosignalanteils im Mikrophonsignal wird eine Nachbildung der Übertragungsstrecke zwischen Audiosignalquelle, bspw. Lautsprecher, Fahrzeuginnenraum und Mikrophon eingesetzt, die mittels eines adaptiven, also eines sich automatisch selbst anpassenden Filters, realisiert wird. Die Wiedergabelautstärke wird dabei so eingestellt, dass deren Pegel stets um einen Differenzpegel über dem ermittelten Störgeräuschpegel liegt. Die Lautstärkesteuerung kann dabei frequenzselektiv in Abhängigkeit der spektralen Verteilung des Störgeräuschs erfolgen, wozu der Pegel des Störgeräusches für einzelne Frequenzbänder bestimmt und die Lautstärke des Wiedergabesignals entsprechend in den einzelnen Frequenzbändern nachgeführt wird.

In einer praktischen Realisierung sind bei Autoradios bei einer ersten Inbetriebnahme zwei Einmessprozeduren vorgesehen. Eine erste Einmessprozedur dient einer automatischen Einmessung eines Equalizers und somit einer Einrichtung zum Tonabgleich zur Kompensation von Unzulänglichkeiten der Übertragungsstrecke zwischen Audiosignalquelle und Ohr des Fahrzeugführers, eine zweite Einmessprozedur dient der Einstellung der automatischen Störgeräuschverdeckung (DNC: Digital Noise Covering).

Zum Einmessen und für den späteren Betrieb der automatischen Lautstärkesteuerung soll das Messmikrophon im Bereich der Konsole dauerhaft befestigt werden. Alternativ kann das Messmikrophon auch im Bereich des Frontscheibenrahmens oder der Sonnenblende befestigt werden.

Somit kann eine Anordnung des Messmikrophons im Bereich der Konsole vermieden werden. Bei dieser herkömmlichen Anordnung existiert zwischen diesem Messort und dem Ort des Kopfes des Fahrzeugführers eine nicht ideale Übertragungsstrecke. Demzufolge erfasst das Messmikrophon an seinem Einbauort ein anderes Signalgemisch als das Gehör des Fahrzeugführers. Ein Grund hierfür sind unter anderem Reflexionen im Fahrzeuginnenraum, die sich an unterschiedlichen Orten verschieden auswirken, sowie Körperschall, der sich in erhöhtem Maße auf das fest eingebaute Messmikrophon überträgt. Diese Faktoren beeinträchtigen die Messungen und damit u.a. die automatische Lautstärkesteuerung.

### Offenbarung der Erfindung

Die Erfindung betrifft ein Verfahren zur automatischen Kontrolle mindestens eines akustischen Parameters einer Audioanlage, bei dem ein Mikrophon einer Sprachgarnitur für eine Telefonanlage im Bereich des Kopfes eines Nutzers der Audioanlage angeordnet und als Messmikrophon verwendet wird.

Eine derartige automatische Kontrolle umfasst üblicherweise eine Steuerung und/oder Regelung des mindestens einen akustischen Parameters, bspw. der Lautstärke der Audioanlage. Es können jedoch auch andere akustische Parameter, in der Regel Frequenzen des Audiosignals, kontrolliert und somit gesteuert und/oder geregelt werden. Dabei ist bei einer Ausgestaltung vorgesehen, dass die Lautstärke frequenzabhängig eingestellt werden kann, wobei bestimmte Frequenzen verstärkt und andere Frequenzen hingegen in ihrer Lautstärke nicht verstärkt werden.

Zur Durchführung des Verfahrens wird als Mess- bzw. Referenzmikrophon das Mikrophon einer Sprachgarnitur, die typischerweise als Headset bezeichnet wird, von einer bspw. mobilen Telefonanlage benutzt. Da die Sprachgarnitur bzw. das Headset auch bei nicht aktiver Nutzung der Telefonanlage am Kopf des Nutzers getragen wird, ist das Messmikrophon zur Durchführung des Verfahrens in der Nähe des Ohrs des Nutzers günstig angeordnet. Durch das Messmikrophon wird demnach jenes Gesamtsignal einer Geräuschkulisse erfasst und somit aufgenommen, dass das von mindestens einem Lautsprecher der Audioanlage bereitgestellte Audiosignal sowie ein durch die Umgebung erzeugtes Störsignal umfasst. Dies bedeutet, dass jenes Gesamtsignal erfasst wird, das der Nutzer tatsächlich hört. Falls sich der Nutzer, der das Mikrophon im Bereich seines Kopfs trägt, bewegen sollte, ist auch eine Kontrolle des mindestens einen akustischen Parameters der Audioanlage nutzerspezifisch in Abhängigkeit seines aktuellen Aufenthaltsorts möglich.

In Ausgestaltung kann das Verfahren betriebsbegleitend durchgeführt werden, so dass der mindestens eine akustische Parameter bedarfsweise permanent und aktuell geregelt werden kann.

In einer Variante ist das vorgestellte Verfahren für eine Audianlage in einem Fahrzeug, bspw. in einem Kraftfahrzeug, geeignet. Diese Verwendung bietet sich u. a. an, da durch Motorgeräusche oder durch einen Fahrtwind einen erheblichen Anteil an Störsignalen zu rechnen ist. Üblicherweise weisen Audioanlagen in Kraftfahrzeugen mehrere Lautsprecher auf, die an unterschiedlichen Positionen angeordnet sind. Eine Ausbreitung von Schall wird außerdem durch eine Innenausstattung bzw. -einrichtung sowie Beladung und/oder Fahrzeuginsassen in einem Innenraum des Kraftfahrzeugs beeinflusst. Wird im Rahmen des Verfahrens nun das in der Nähe des Kopfes angeordnete Mikrophon einer Sprachgarnitur einer Telephonanlage verwendet, können bei der Kontrolle des mindestens einen akustischen Parameters auch Einflüsse der Einrichtung bzw. Ausstattung sowie Beladung und/oder Fahrzeuginsassen berücksichtigt werden.

In einer Ausführungsform des Verfahrens wird von dem Mikrophon eine herrschende Geräuschkulisse als Gesamtsignal erfasst. Das Mikrophon erfasst das Gesamtsignal aus Störgeräusch und Audio- bzw. Nutzersignal am Ort des Kopfes des Fahrers. Dieses Gesamtsignal wird an die Audioanlage übermittelt.

Das Gesamtsignal umfasst somit ein von der Audioanlage ursprünglich bereitgestelltes Audiosignal und ein von der Umgebung erzeugtes Störsignal. Bei Umsetzung des Verfahrens kann mindestens ein akustischer Parameter des Störsignals durch Vergleich mindestens eines akustischen Parameters des Gesamtsignals mit mindestens einem akustischen Parameter des Audiosignals ermittelt werden. Dabei korreliert das Gesamtsignal mit dem in der Audioanlage bekannten Nutzsignal. Ein Einfluss der Übertragungsstrecke zwischen der Audioanlage und dem Mikrophonsignal kann bspw. mit einem adaptiven Filter herausgerechnet werden. Ein Differenzsignal zwischen dem Audiosignal und dem gefilterten Gesamtsignal entspricht dem Störsignal, insbesondere dem Fahrgeräusch. Der mindestens eine akustische Parameter des Audiosignals wird in Abhängigkeit des mindestens einen akustischen Parameters des Störsignals geregelt, bspw. aktuell nachgeregelt.

Durch geeignete Regelung des mindestens einen akustischen Parameters des Audiosignals, üblicherweise der Lautstärke des Autosignals, können Störgeräusche aus der Umgebung, die das Störsignal erzeugen, akustisch überdeckt werden. Zum Regeln des mindestens einen akustischen Parameters der Audioanlage und somit auch zum Regeln der Audioanlage kann, falls eine ggf. frequenzabhängige Regelung der Lautstärke vorgesehen ist, eine Lautstärke des Audiosignals erhöht werden, falls das Störsignal lauter werden sollte. Für den Fall, dass das Störsignal leiser wird, kann die Lautstärke des Autosignals auch verringert werden.

Darüber hinaus kann dem Audiosignal auch ein Kompensationssignal zur Kompensation der Störgeräusche überlagert werden.

Für den Fall, dass der Nutzer der Audioanlage sowie der Telefonanlage ein Telefonat führt, kann in einer weiteren möglichen Variante des Verfahrens vorgesehen sein, dass der mindestens eine akustische Parameter für einen Zeitraum, in dem das Telefonat stattfindet, ebenfalls geregelt wird. Infolge dessen kann die Audioanlage derart eingestellt werden, dass die Lautstärke in geeigneter Weise reduziert wird, so dass der Nutzer während des Telefonats nicht gestört wird.

Es wird weiterhin auf die bereits als Stand der Technik gewürdigte Druckschrift EP 0 319 777 B1 verwiesen. Die darin offenbarten Aspekte können auch im Rahmen der vorliegenden Erfindung als zusätzliche Ausführungsformen umgesetzt werden.

Mit dem Verfahren ist u. a. eine automatische störgeräuschabhängige Regelung des mindestens einen akustischen Parameters, in der Regel der Lautstärke der Audioanlage, möglich. Mit Hilfe des Mikrophons, das dem Audiosignal bzw. Nutzschall und dem Störgeräusch ausgesetzt ist, wird das Gesamtsignal am Ohr des Nutzers erfasst. Dabei kann dem Audiosignal ein regelndes Signal für den mindestens einen akustischen Parameter überlagert werden.

Bei einer Variante kann eine Auswertung einer Korrelation zwischen dem Gesamtsignal und dem Audiosignal adaptiert werden. Außerdem kann das Audiosignal innerhalb des gesamten übertragenen Frequenzbereichs zur Ableitung des weiteren regelnden Signals verwendet werden.

In Ausgestaltung kann das Audiosignal in mehrere Signale verschiedener Frequenzbereiche aufgeteilt werden, wobei für jeden Frequenzbereich eine Ableitung eines weiteren Signals und eine Überlagerung mit dem Gesamtsignal des betreffenden Frequenzbereichs erfolgt.

Die Erfindung betrifft auch eine Verwendung eines Mikrophons, das als Komponente einer Sprachgarnitur für eine mobile Telefonanlage sowie als Referenzmikrophon zur automatischen Kontrolle mindestens eines akustischen Parameters einer Audioanlage ausgebildet und zur Durchführung der Kontrolle im Bereich eines Kopfs eines Nutzers der Audioanlage anzuordnen ist.

In Ausgestaltung ist das zu verwendende Mikrophon dazu ausgebildet, eine herrschende Geräuschkulisse als Gesamtsignal zu erfassen und Informationen über mindestens einen akustischen Parameter des Gesamtsignals an die Audioanlage zu übermitteln.

Die erfindungsgemäß vorgesehene Audioanlage ist dazu ausgebildet, mit einem Mikrophon einer Sprachgarnitur für eine mobile Telefonanlage zusammenzuwirken, das als Referenzmikrophon zur automatischen Kontrolle mindestens eines akustischen Parameters der Audioanlage ausgebildet und im Bereich eines Kopfes eines Nutzers der Audioanlage anzuordnen ist.

Diese Audioanlage kann als mindestens eine Komponente mindestens einen Lautsprecher zur Bereitstellung eines Audiosignals ein Empfangsmodul und/oder eine Steuereinrichtung aufweisen. Das Empfangsmodul ist dazu ausgebildet, von dem Mikrophon übermittelte Informationen zu mindestens einem akustischen Parameter eines von dem Mikrophon erfassten Gesamtsignals einer Geräuschkulisse zu empfangen. Die Steuereinrichtung ist dazu ausgebildet, auf Grundlage des mindestens einen akustischen Parameters des Gesamtsignals mindestens einen akustischen Parameter eines Audiosignals der Audioanlage zu steuern.

Eine Vorrichtung, die das Mikrophon und die Audioanlage umfasst, ist dazu ausgebildet, sämtliche Schritte des vorgestellten Verfahrens durchzuführen. Dabei können einzelne Schritte dieses Verfahrens auch von einzelnen Komponenten der mindestens einen Vorrichtung durchgeführt werden. Weiterhin können Funktionen der Vorrichtung oder Funktionen von einzelnen Komponenten der mindestens einen Vorrichtung als Schritte des Verfahrens umgesetzt werden. Typischerweise wird von dem Mikrophon in der Nähe des Kopfes des Nutzers das Gesamtsignal erfasst. Eine Regelung des Audiosignals unter Berücksichtigung des jeweils aktuell erfassten Gesamtsignals erfolgt durch die Audioanlage.

Die Erfindung betrifft weiterhin ein Computerprogramm mit Programmcodemitteln, um alle Schritte eines beschriebenen Verfahrens durchzuführen, wenn das Computerprogramm auf einem Computer oder einer entsprechenden Recheneinheit, insbesondere in einem erfindungsgemäßen Mikrophon und/oder einer erfindungsgemäßen Audioanlage ausgeführt wird.

Das erfindungsgemäße Computerprogrammprodukt mit Programmcodemitteln, die auf einem computerlesbaren Datenträger gespeichert sind, ist zum Durchführen aller Schritte eines beschriebenen Verfahrens ausgebildet, wenn das Computerprogramm auf einem Computer oder einer entsprechenden Recheneinheit, insbesondere in einen erfindungsgemäßen Mikrophon und/oder einer erfindungsgemäßen Audianlage, ausgeführt wird.

Als Referenz- bzw. Messmikrophon für die automatische Lautstärkesteuerung wird somit anstelle oder ergänzend zu dem vorhandenen Messmikrophon das Mikrophon eines Headsets für eine Telefonanlage mit Mikrophon verwendet.

Das in Ausgestaltung verwendete Messmikrophon, also das Headset-Mikrophon, ist im Bereich des Kopfs des Fahrzeugführers angeordnet und damit in der Nähe der Ohren des Fahrzeugführers, also im wesentlichen dort, wo die automatische Kontrolle des mindestens einen akustischen Parameters und somit insbesondere die Lautstärkesteuerung räumlich wirken soll. Damit werden Auswirkungen von Unzulänglichkeiten der Übertragungsstrecke zwischen dem Ohr des Nutzers bzw. Fahrzeugführers und dem Messmikrophon auf die automatische Lautstärkesteuerung im wesentlichen ausgeschaltet. Auch wechselnde Beladungen oder Sitzplatzbelegungen des Fahrzeugs bleiben damit ohne Auswirkung auf die Lautstärkesteuerung, da diese betriebsbegleitend aktualisiert werden kann.

Weiterhin ergibt sich, dass das Messmikrophon nicht mit Fahrzeugteilen fest verbunden ist, so dass eine Übertragung von Körperschall auf das Messmikrophon ausgeschlossen wird. Es wird allenfalls derjenige Körperschall auf das Messmikrophon eingekoppelt, der auch auf das Ohr des Fahrzeugführers einwirkt. Die hier vorgeschlagene Erfindung kann alternativ oder ergänzend auch eine Anordnung des Mikrophons in der Kopfstütze des Fahrersitzes und somit in Kopfhöhe umfassen. Das Mikrophon kann typischerweise derart angeordnet sein, dass es annähernd genau das aufnimmt, was auch das Gehör des Fahrzeugführers aufnimmt.

Das bspw. als Komponente eines Headset ausgebildete Mikrophon ist für eine Freisprecheinrichtung im Fahrzeug üblicherweise vorgesehen. Es steigt somit die Motivation zur Benutzung eines Telefon-Headsets und damit einer Telefon-Freisprecheinrichtung.

Telefon-Headsets verfügen derzeit regelmäßig über Bluetooth-Schnittstellen zur Ankopplung an eine Freisprecheinrichtung. Somit ist eine Bereitstellung der Informationen ausgehend von dem Mikrophon zu der Audioanlage über Bluetooth möglich. Die Übermittlung der Informationen kann jedoch auch mit jedem anderen geeigneten drahtlosen oder auch drahtgebundenen Übertragungsmittel erfolgen.

Ein separates Messmikrophon, wie es bisher zur Verdeckung von Störgeräuschen verwendet wird, kann somit vollständig eingespart werden, dadurch entfällt u.a. der Aufwand für die Verkabelung des Messmikrophons.

Im Rahmen der Erfindung ist u. a. die Nutzung eines Freisprech-Headset-Mikrophons zur Steuerung der automatischen Störgeräuschverdeckung (D[igital] N[oise] C[overing]) im Fahrzeug vorgesehen. Die Erfindung ermöglicht die automatische Lautstärkesteuerung zur Störgeräuschverdeckung für eine Audioanlage, typischerweise einem Autoradio in einem Kraftfahrzeug. Mit dieser Lautstärkesteuerung ist es möglich, Störgeräusche im Fahrzeuginnenraum, die sich beispielsweise aus einem Motorgeräusch, einem Reifenabrollgeräusch, Windgeräuschen und dergleichen zusammensetzen, dadurch zu verdecken, dass die Lautstärke einer Audiowiedergabe, bevorzugt frequenzselektiv, so weit angehoben wird, dass ein ausreichender Differenzpegel zwischen Störgeräusch und Audiosignalpegel hergestellt ist.

Weitere Vorteile und Ausgestaltungen der Erfindung ergeben sich aus der Beschreibung und der beiliegenden Zeichnung.

Es versteht sich, dass die voranstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

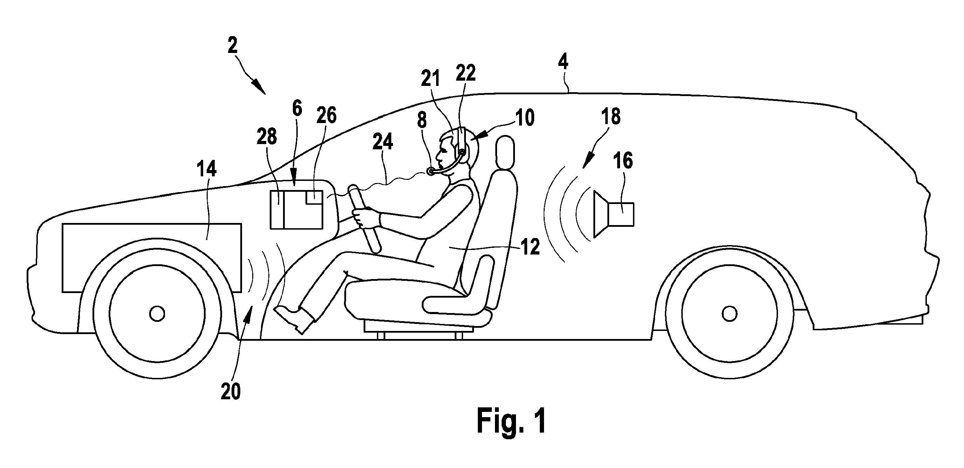

Kurze Beschreibung der Zeichnung
- Figur 1: zeigt in schematischer Darstellung eine Anordnung, die eine Ausgestaltung einer erfindungsgemäßen Audioanlage und eine Ausgestaltung eines erfindungsgemäßen Mikrophons umfasst.

### Ausführungsform der Erfindung

Die Erfindung ist anhand einer Ausführungsform in der Zeichnung schematisch dargestellt und wird im folgenden unter Bezugnahme auf die Zeichnungen ausführlich beschrieben.

Figur 1 zeigt in schematischer Darstellung eine Anordnung 2, die innerhalb eines Fahrzeugs 4 angeordnet ist, und eine Ausführungsform einer erfindungsgemäßen Audioanlage 6 sowie eine Ausführungsform eines erfindungsgemäßen Mikrophons 8, das als Teil einer Sprachgarnitur 10 für eine mobile, hier nicht weiter dargestellte Telefonanlage ausgebildet ist, aufweist.

Figur 1 zeigt weiterhin einen Nutzer 12 bzw. Fahrer des Fahrzeugs 4, einen Motor 14 und einen Lautsprecher 16.

Falls während der Fahrt die Audioanlage 6 eingeschaltet ist, wird von dem Lautsprecher 16, der mit der Audioanlage 6 zusammenwirkt, ein Audiosignal 18 zur Beschallung des Innenraums des Fahrzeugs 4 bereitgestellt. Allerdings wird ebenfalls durch den laufenden Motor 14 ein Störsignal 20 erzeugt, das eine akustische Wahrnehmung des Audiosignals 18 durch den Nutzer 12 beeinträchtigen kann.

Bei einer Ausführungsform des erfindungsgemäßen Verfahrens ist vorgesehen, dass das in der Nähe eines Ohrs im Bereich des Kopfs 21 des Nutzers 12 angeordnete Mikrophon 8 der Sprachgarnitur 10, die weiterhin einen Kopfhörer 22 aufweist, ein Gesamtsignal einer Geräuschkulisse, das sich aus dem Audisignal 18 und dem Störsignal 20 zusammensetzt, erfasst und somit aufgenommen wird.

Während des Betriebs der Audianlage 6 kann das Mikrophon 8 kontinuierlich oder ggf. in zeitlichen Abständen Informationen 24 über mindestens einen akustischen Parameter des sich aus dem Audiosignal 18 und dem Störsignal 20 zusammensetzenden Gesamtsignal drahtlos an ein Empfangsmodul 26 des Steuergeräts übermitteln. Vorzugsweise wird das Gesamtsignal vom Mikrophon 8 an die Audioanlage 6 übermittelt. Die Audioanlage 6 leitet daraus den mindestens einen zu berücksichtigenden Parameter ab.

Weiterhin umfasst die hier gezeigte Audioanlage 6 eine Steuereinrichtung 28, die dazu geeignet ist, eine Größe des mindestens einen akustischen Parameters des Störsignals 20 zu erfassen. Dies erfolgt in der vorliegenden Ausführungsform dadurch, dass die Informationen 24 zu dem mindestens einen akustischen Parameter des Gesamtsignals mit mindestens einem akustischen Parameter des Audiosignals, wobei ein derartiger Parameter der Audioanlage 6 bekannt ist, verglichen wird. In Abhängigkeit der Größe des mindestens einen akustischen Parameters des Störsignals 20 kann das Audiosignal 18 in geeigneter Weise nachgeregelt, wie bspw. verstärkt, werden, falls das Störsignal 20 lauter werden sollte.

Im Rahmen des Verfahrens wird das Mikrophon 8 der Sprachgarnitur 10 für die Telefonanlage als Mess- bzw. Referenzmikrophon zum Erfassen des Gesamtsignals der Geräuschkulisse benutzt. Da das Mikrophon 8 am Kopf 21 des Nutzers 12 und somit auch in der Nähe seines Ohrs angeordnet ist, kann eine nutzerspezifische, situationsbedingte automatische Kontrolle des mindestens einen akustischen Parameters der Audioanlage 6 durchgeführt werden.

In der vorliegenden Ausführungsform ist bspw. vorgesehen, dass in der Audioanlage 6 von dem Gesamtsignal, das durch das Mikrophon 8 erfasst wird, das Audiosignal 18, das der Audioanlage 6 bekannt ist, abgezogen und somit ein Wert für das Störsignal 20 im Bereich des Kopfes 21 des Nutzers 12 berechnet wird. Auf Grundlage dieses Werts für das Störsignal 20 wird von der Audioanlage 8 die Regelung des Audiosignals 18 durchgeführt. Hierzu kann von der Audioanlage 8 ein geeignetes regelndes Signal erzeugt werden, durch das typischerweise frequenzseletiv Werte bereitgestellt werden, um bestimmte Frequenzen des Audiosignals 18 je nach Größe des Störsignals zu verstärken oder zu reduzieren.

## Patentansprüche

1. Verfahren zur automatischen Kontrolle mindestens eines akustischen Parameters einer Audioanlage (6), bei dem ein Mikrophon (8) einer Sprachgarnitur (10) für eine Telefonanlage im Bereich des Kopfes (21) eines Nutzers (12) der Audioanlage (6) angeordnet und als Messmikrophon verwendet wird.

2. Verfahren nach Anspruch 1, bei dem als der mindestens eine akustische Parameter die Lautstärke der Audioanlage (6) gesteuert wird.

3. Verfahren nach Anspruch 1 oder 2, das für eine Audioanlage (6) in einem Kraftfahrzeug (4) durchgeführt wird.

4. Verfahren nach einem der voranstehenden Ansprüche, bei dem von dem Mikrophon eine herrschende Geräuschkulisse als Gesamtsignal erfasst wird, und bei dem von dem Mikrophon (8) Informationen (24) über mindestens einen akustischen Parameter des Gesamtsignals an die Audioanlage (6) übermittelt werden.

5. Verfahren nach einem der voranstehenden Ansprüche, bei dem vorgesehen ist, dass das Gesamtsignal ein von der Audioanlage (6) ursprünglich bereitgestelltes Audiosignal (18) und ein von der Umgebung erzeugtes Störsignal (20) umfasst, wobei mindestens ein akustischer Parameter des Störsignals (20) durch Vergleich mindestens eines akustischen Parameters des Gesamtsignals mit mindestens einem akustischen Parameter des Audiosignals (8) ermittelt wird, und wobei der mindestens eine akustische Parameter des Audiosignals (8) in Abhängigkeit des mindestens einen akustischen Parameters des Störsignals (20) geregelt wird.

6. Verwendung eines Mikrophons, das als Komponente einer Sprachgarnitur (10) für eine Telefonanlage sowie als Messmikrophon zur automatischen Kontrolle mindestens eines akustischen Parameters einer Audioanlage (6) ausgebildet und zur Durchführung der Kontrolle im Bereich eines Kopfs (21) eines Nutzers (12) der Audioanlage (6) anzuordnen ist.

7. Verwendung eines Mikrophons nach Anspruch 6, das dazu ausgebildet ist, eine herrschende Geräuschkulisse als Gesamtsignal zu erfassen und Informationen (24) über mindestens einen akustischen Parameter des Gesamtsignals an die Audioanlage (6) zu übermitteln.

8. Audioanlage, die dazu ausgebildet ist, mit einem Mikrophon (8) einer Sprachgarnitur (10) für eine Telefonanlage zusammenzuwirken, das als Messmikrophon zur automatischen Kontrolle mindestens eines akustischen Parameters der Audioanlage (6) ausgebildet und im Bereich eines Kopfes (21) eines Nutzers (12) der Audioanlage (6) anzuordnen ist.

9. Audioanlage nach Anspruch 8, die mindestens ein Empfangsmodul (26) und eine Steuereinrichtung (28) aufweist, wobei das Empfangsmodul (26) dazu ausgebildet ist, von dem Mikrophon (8) übermittelte Informationen (24) zu mindestens einem akustischen Parameter eines von dem Mikrophon erfassten Gesamtsignals einer Geräuschkulisse zu empfangen, und wobei die Steuereinrichtung (28) dazu ausgebildet ist, auf Grundlage des mindestens einen akustischen Parameters des Gesamtsignals mindestens einen akustischen Parameter eines Audiosignals (18) der Audioanlage (16) zu steuern.

10. Computerprogramm mit Programmcodemitteln, um alle Schritte eines Verfahrens nach einem der Ansprüche 1 bis 5 durchzuführen, wenn das Computerprogramm auf einem Computer oder einer entsprechenden Recheneinheit, insbesondere in einem Mikrophon (8) nach Anspruch 6 oder 7 und/oder in einer Audioanlage (6) nach Anspruch 8 oder 9, ausgeführt wird.

11. Computerprogrammprodukt mit Programmcodemitteln, die auf einem computerlesbaren Datenträger gespeichert sind, um alle Schritte eines Verfahrens nach einem der Ansprüche 1 bis 5 durchzuführen, wenn das Computerprogramm auf einem Computer oder einer entsprechenden Recheneinheit, insbesondere in einem Mikrophon (8) nach Anspruch 6 oder 7 und/oder in einer Audioanlage (6) nach Anspruch 8 oder 9, ausgeführt wird.
